# EUROPÄISCHE PATENTANMELDUNG

(11) **EP 2 323 176 A1**
(43) Veröffentlichungstag der Anmeldung: **18.05.2011**
(21) Anmeldenummer: 09014266.2
(22) Anmeldetag: 16.11.2009
(51) Int. Cl.: H01L 31/052

(54) **Photoelektrisches Konzentratormodul**

(71) Anmelder: 'Telecom-STV' Company Limited, Moscow 124498 (RU)
(72) Erfinder: Alexeev, Alexey V.,, Zelenograd, Moscow 124681 (RU); Belusov, Victor S.,, Zelenograd, Moscow 124575 (RU); Eidelman, Boris L.,, Zelenograd, Moscow 124683 (RU)
(74) Vertreter: Jeck, Anton

(57) **Zusammenfassung**

Das photoelektrische Konzentratormodul besteht aus linearen Fresnel-Linsen, einer Kette von lichtempfindlichen Sensoren und einer mit der Außenluft verbundenen Schleusenbaugruppe. Die Schleusenbaugruppe dient zum Schutz des Modulinnenraums gegen Luftfeuchtigkeit und ist als mit Luftfeuchtigkeitssorbens gefüllte Rohre (z. B. Metallrohre) ausgebildet. Die Rohre sind parallel zu den Reihen von Sonnenzellen neben den Seitenwänden des Moduls angeordnet. Um die Rückgewinnung des Sorptionsmittels sicherzustellen, sind die Rohre durch zusätzliche Konzentratoren des Sonnenlichtstroms aus der Basis von linearen Fresnel-Linsen erwärmt. Die Fresnel-Linsen befinden sich neben und gleichläufig mit den linearen Haupt-Fresnel-Linsen und dienen als Sonnenstrahlungskonzentratoren auf der Oberfläche einer Reihe von lichtempfindlichen Sensoren. Das vorgeschlagene photoelektrische Konzentratormodul mit einer Schleusenbaugruppe mit regenerierbarem Feuchte auf nehmendem Stoff (z. B. Kieselgel) ermöglicht es, den Feuchtigkeitsniederschlag auf den Bauteilen innerhalb des Moduls völlig auszuschließen. Dadurch wird die Stabilität der elektrophysikalischen und optischen Kennlinien des Moduls sichergestellt.

## Beschreibung

Die Erfindung betrifft ein photoelektrisches Konzentratormodul nach dem Oberbegriff des Anspruchs 1.

Die Erfindung kann auf dem Gebiet der Solarenergie eingesetzt werden und betrifft insbesonders photoelektrische Konzentratormodule. Die Erfindung kann besonders erfolgreich in den Land-Sonnenenergieanlagen auf der Basis der linearen Sonnenstrahlungskonzentratoren angewendet werden, welche für die autonomen Energieversorgungsanlagen und Eigenspeisungssysteme in unterschiedlichen Klimagebieten eingesetzt werden können

Die Anwendung von Sonnenstrahlungssammlern ermöglicht es bekanntlich, die Effizienz der photoelektrischen Module zu steigern und ihre Energie- und ihre wirtschaftlichen Kennziffern zu verbessern. Das ist allerdings nur unter der Voraussetzung möglich, dass die Kenndaten des Strahlungssammlers auf die Kenndaten der Sonnenzellen abgestimmt sind. Diese Verbesserung ist durch eine Minderung des Verbrauchs von kostspieligen Halbleitermaterialien möglich [1].

Die Konstruktion der photoelektrischen Module mit Sonnenstrahlungsammlern soll ihren Langzeitbetrieb unter den tatsächlichen Betriebsbedingungen sicherstellen. Die Anwendung der photoelektrischen Module erfolgt unter den Naturbedingungen der Umwelt. Deswegen muss der Schutz des optischen Systems, der Halbleitereinheiten und der Strom ableitenden Kontakte vor solchen Einwirkungen wie Temperatur- und Druckschwankungen, hohe Feuchtigkeit, Wind und Staub sichergestellt werden.

Aus [2] ist ein photoelektrisches Modul mit linearen Sonnenstrahlungskonzentratoren bekannt, dessen photoelektrische Module gegen die Einwirkung der Umwelt durch eine durchsichtige Dichtungsmasseschicht auf Kunststoffbasis geschützt sind.

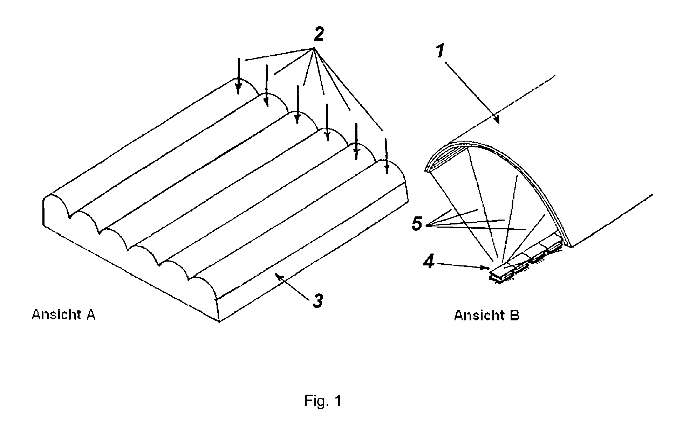

Der Aufbau des Moduls ist anhand der Fig. 1 erklärt.

Die Ansicht A zeigt die Außenansicht des Moduls. In der Ansicht B ist ein Element der Modulkonstruktion dargestellt (Fresnel-Linse mit einer Reihe von Halbleiter-Photowandlern). Die Fresnel-Linsen 1 sind aus organischem Glas gefertigt. Um den Schutz gegen Witterungseinflüsse sicherzustellen, sind die Linsen auf der der einfallenden Sonnenstrahlung 2 entgegengesetzten Glasoberfläche ausgebildet. Das Gehäuse 3 ist aus Metallmaterial gefertigt, um eine wirkungsvolle Wärmeabführung von den Halbleiter-Photowandlern 4 unter der Einwirkung einer konzentrierten Sonnenstrahlung 5 zu erreichen.

Der Nachteil dieser Bauweise ist eine Undichtigkeit des Innenraums des photoelektrischen Moduls zur Umwelt. Deswegen kann bei einer Änderung der Temperatur-und Wetterbedingungen innerhalb des photoelektrischen Moduls eine Kondensation von Luftfeuchtigkeitsdämpfen zustande kommen. Das verhindert eine wirkungsvolle Umwandlung der Sonnenstrahlung in elektrische Energie mindestens so lange, bis die Lufttemperatur im Innenraum des Moduls die Taupunkttemperatur der Dämpfe überschreitet. Die Feuchte im Innenraum des photoelektrischen Moduls wirkt sich auch negativ auf die Funktion der optischen Elemente des Moduls aus und bedingt eine Korrosion des Gehäuses und der Metallbauteile des Moduls. Das verkürzt die Standzeit der photoelektrischen Umwandler.

Der der Erfindung nächste Stand der Technik seinem technischen Wesen und dem erreichten Ergebnis nach ist ein photoelektrisches Modul, welches lineare Fresnel-Linsen, eine Kette von lichtempfindlichen Sensoren und eine Einrichtung zum Schutz des Innenraums gegen Witterungseinflüsse enthält. Ein solches photoelektrisches Modul ist aus Glasplatten gefertigt, die mittels einer Kleberdichtungsmasse miteinander verbunden sind [3].

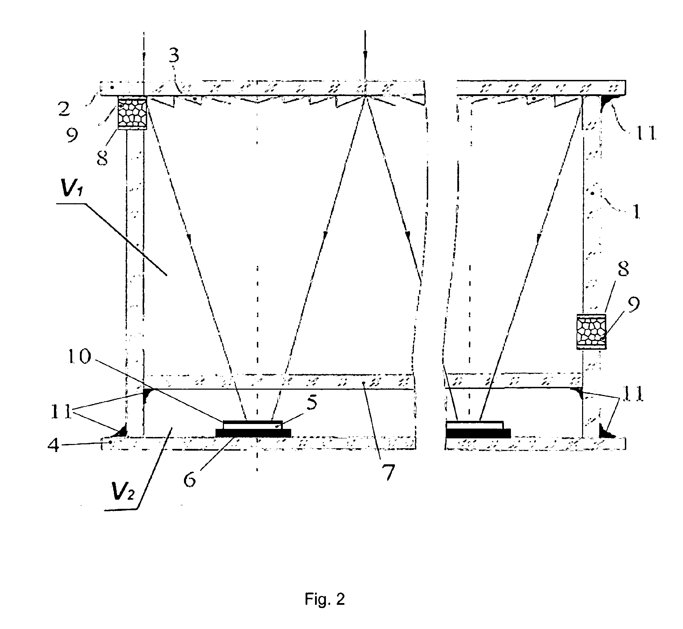

Der Aufbau dieses Moduls ist anhand der Fig. 2 erklärt.

Das Modul besteht aus einem Hauptinnenraum V₁ und den speziell geformten abgedichteten und lichtdurchlässigen Abteilungen V₂. Die Fresnel-Linsen 3 aus Silikon sind im Hauptinnenraum V₁ angeordnet. In der lichtdurchlässigen Abteilung V₂ sind reihenweise lichtempfindliche Sensoren 10 (Sonnenzellen) angeordnet. Die Fresnel-Linsen 3 sind auf der Rückseite einer Glasoberfläche 2 ausgebildet, die senkrecht zum Sonnenlichtfluss ausgerichtet ist.

Der Lichtfluss ist auf die Oberfläche der Sonnenzellen 10 konzentriert. Die Sonnenzellen 10 sind in den abgedichteten Abteilungen V₂ des Moduls angeordnet. Diese Modulabteilungen V₂ sind aus flachen Glasfragmenten 4 und 7 gefertigt, die mit einer Kleberdichtungsmasse 11 verklebt sind. Die Sonnenzellen 10 sind über eine nicht leitende Zwischenschicht 5 auf einer Wärme abführenden Unterlage 6 auf der Basis von metallisiertem Hartgewebe mit entsprechender Verdrahtung angeordnet.

Die Luft wird aus den abgedichteten Abteilungen V₂ abgesaugt, um den Schutz der Sonnenzellen 10 gegen Witterungseinflüsse sicherzustellen. Der Hauptinnenraum V₁ des photoelektrischen Moduls ist dagegen über Hohlrohre 8 mit der Außenluft verbunden, da die Luft wegen einer eventuell möglichen Verformung der Konstruktion unter bedeutenden Temperaturschwankungen des inneren Luftraums nicht abgesaugt werden darf.

Die Mängel einer solchen Konstruktion sind wie folgt:
Da der Innenraum V₁ des Moduls mit der Außenluft über die Rohre 8 verbunden ist, ist der Schutz dieses Raums V₁ gegen Feuchte und Staub nicht sichergestellt.
Wenn die Hohlrohre 8 in einem Einzelfall sogar mit Filtergut 9 (zum Beispiel mit Kieselgel-Granulat oder einem ähnlichen Feuchte aufnehmenden Stoff) gefüllt sind, kann der Schutz gegen Feuchtigkeit nur einmal sichergestellt werden. Das liegt daran, dass die Konstruktion des Moduls keine Möglichkeit einer Rückvergütung (Regenerierung) des Feuchte aufnehmenden Stoffes vorsieht. Nach der erfolgten Entlüftung bleibt die Restmenge von Feuchtigkeit in den abgedichteten Abteilungen V₂ erhalten.
Im Falle von wesentlichen Temperaturschwankungen, die durch die eigentliche Funktion des Moduls bedingt sind, kann die Feuchte auf der Oberfläche der Sonnenzellen 10 kondensieren.
Die komplizierte Konstruktion des Moduls begrenzt wesentlich seine Funktionalitäten und die Reparierbarkeit.
Es ist Aufgabe der Erfindung, den Schutz eines photoelektrischen Konzentratormoduls auf der Basis der linearen Fresnel-Linsen gegen Luftfeuchtigkeit zu verbessern.
Die gestellte Aufgabe der Erfindung wird durch die Merkmale des Anspruchs 1 gelöst.

### Dies wird folgenderweise erreicht:

Das bekannte photoelektrische Konzentratormodul enthält lineare Fresnel-Linsen, eine Kette von lichtempfindlichen Sensoren 2 und mit der Außenluft verbundene Hohlrohre 4. Dabei sind zum Schutz des Moduls gegen Luftfeuchtigkeit mit einem Luftfeuchtigkeitssorptionsmittel gefüllten Rohre 4 (z. B. aus Metall) eingesetzt. Die Rohre 4 sind parallel zu den Reihen von Sonnenzellen 2 neben den Seitenwänden des Moduls angeordnet. Die Seitenwände werden durch zusätzliche Konzentratoren des Sonnenlichtstroms auf der Basis von linearen Fresnel-Linsen 3 erwärmt. Die Fresnel-Linsen 3 befinden sich neben und gleichläufig mit den linearen Haupt-Fresnel-Linsen 1 und dienen als Sonnenstrahlungskonzentratoren auf der Oberfläche einer Reihe von lichtempfindlichen Sensoren 2.

Weitere vorteilhafte Ausgestaltungen des photoelektrischen Konzentratormoduls sind den Unteransprüchen zu entnehmen.

Die Anwendung einer solchen Ausführungsform stellt eine Isolation des photoelektrischen Moduls gegenüber den Einwirkungen von Staub und Feuchte sicher. Sinkt die Temperatur des Moduls am Abend bzw. in der Nacht, so gibt es keinen Feuchtigkeitsniederschlag auf den optischen Oberflächen der Fresnel-Linsen 1 und 3 sowie auf den durch einen Silikonfilm geschützten Oberflächen der photoelektrischen Elemente bzw. auf den Seitenwänden 8 des Moduls. Das ist dank dem hohen Adsorptionsvermögen des Sorptionsmittels, d.h. seiner Fähigkeit, die im Innenraum des Moduls vorhandene Feuchtigkeit aufzunehmen, erklärt. Bei einer hellen Sonnenstrahlung steigt die Modultemperatur und insbesondere die Temperatur der Reihe von lichtempfindlichen Sensoren 2 und den mit Sorptionsmittel gefüllten Rohren 4. Dabei nimmt der Desorptionsgrad der Wasserdämpfe aus dem Sorptionsmaterial unter der Einwirkung einer konzentrierten Sonnenstrahlung von den zusätzlichen Fresnel-Linsen 3 wesentlich zu. Unter der Einwirkung des erhöhten Luftdrucks im Modulinnenraum und während der Funktion des Moduls unter den Bedingungen einer intensiven Sonnenbelichtung werden die freigesetzten Wasserdämpfe in die das Modul umgebende Außenluft hinaus gestoßen. Damit ist ein Kondensationsvorgang der Wasserdämpfe innerhalb des Innenraums des photoelektrischen Moduls bei wechselnden Betriebstemperaturen ausgeschlossen.

Die bekannten wissenschaftlichen und technischen Fundstellen beschreiben keine Lösungen einer ähnlichen Aufgabe, welche die Anwendung des Verfahrens zum Schutz des Innenraums des photoelektrischen Moduls auf der Basis von linearen Fresnel-Linsen 1 und 3 gegen die Luftfeuchtigkeit vorsehen, wobei Rohre 4 eingesetzt sind, die den Innenraum des Moduls mit der Außenluft verbinden und mit Luftfeuchtigkeitssorbens gefüllt sind, und wobei die Konstruktion des Moduls eine Rückgewinnung des Feuchtigkeit aufnehmenden Stoffes in der Schleusenbaugruppe sicherstellt.

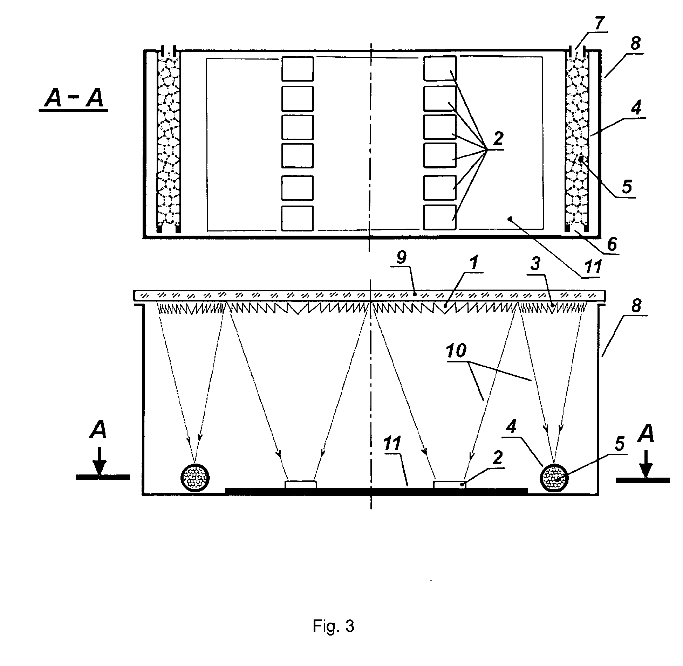

Die Erfindung wird an einem Ausführungsbeispiel anhand der Figur 3 näher erläutert. Das Wesen der Erfindung wird anhand Figur 3 erklärt. Hier ist die angemeldete Bauweise des Moduls schematisch dargestellt.

Die Bereiche 1 kennzeichnen die linearen Haupt-Fresnel-Linsen, welche die Sonnenstrahlung 10 auf die Oberfläche der lichtempfindlichen Sensoren bzw. der Reihen von Sonnenzellen 2 konzentrieren. Die Bereiche 3 kennzeichnen lineare Hilfs-Fresnel-Linsen, die einen Teil der Sonnenstrahlung 10 auf der Oberfläche einer Schleusenbaugruppe konzentrieren. Die Schleusenbaugruppe ist in Form von mit Sorbens 5 gefüllten Rohren 4 ausgeführt. Diese Rohre 4 verbinden den Innenraum des Moduls über die Stirnflächen 6 mit der Umgebung über die Stirnflächen 7 des Moduls.

Die Haupt-Fresnel-Linsen 1 sind aus Silikon auf einer Glasunterlage 9 ausgebildet. Die Hilfs-Fresnel-Linsen 3 haben die gleiche Ausführung und sind neben den Hauptlinsen angeordnet. Die Reihen von Sonnenzellen 2 sind auf einer Metallunterlage des Gehäuses 8 angeordnet. Jedoch sind sie davon durch eine Wärme abführende nichtleitende Schicht 11 abgetrennt. Alle Sonnenzellen 2 sind in Serie geschaltet. Die elektrischen Ableitungen sind über abisolierte Klemmen auf den Seitenflächen 8 des Moduls nach außerhalb herausgeführt.

Die Hilfs-Fresnel-Linsen (3) sind so ausgebildet, dass sie den Sonnenlichtstrom 10 auf die mit Sorptionsmittel gefüllten Rohre 4 konzentrieren. Die Rohre 4 sind mit einer geschwärzten Oberfläche versehen, um das höchstmögliche Aufnahmevermögen der konzentrierten Lichtstrahlen 10 zu erreichen. Das ist zur Sicherstellung einer effizienten Desorption der Wasserdämpfe aus dem Sorptionsmittel durch eine Erhöhung der Rohrtemperatur unter Einwirkung eines intensiven Lichtstroms erforderlich. Als Sorbens kann ein beliebiger Feuchtigkeit aufnehmender Stoff (z.B., Kieselgel) mit einer Rückgewinnungstemperatur von 45+100°C eingesetzt sein. Das Gehäuse 8 des Moduls ist aus Metall (z.B. Aluminium) ausgeführt, um eine wirkungsvolle Wärmeabführung von den Sonnenzellen 2 zu erreichen. Das Gehäuse 8 weist eine steife Bauweise auf, um das präzise Fokussieren des Lichtstroms auf die Oberfläche der Reihe von lichtempfindlichen Sensoren 2 und auf die Oberfläche der Rohre 4 der Schleusenbaugruppe sicherzustellen.

Die angemeldete Ausführungsform des photoelektrischen Moduls weist eine einfache Konstruktion auf und ist weder staub- noch feuchteanfällig. Dies stellt einen Langzeitbetrieb des Moduls unter den Bedingungen einer erhöhten Feuchtigkeit und unter veränderlichen Temperatur- und Witterungsbedingungen weitgehend sicher.

Das photoelektrische Konzentratormodul (Fig. 3) stellt einen rechteckigen Metallbehälter 8 und einen mit Klebeabdichtungsmasse angeklebten Glasdeckel 9 dar. Der Glasdeckel 9 ist aus einem vorgespannten 2 mm starken Glas der Marke «PILKINTON» mit einem Durchsichtigkeitsgrad (beim Wellenlängenbereich von 0,3 bis 1,2 µm) von mindestens 96% gefertigt. Auf der inneren Oberfläche des Glasdeckels 9 sind die linearen Haupt- 1 und Hilfs-Fresnel-Linsen 3 aus Silikon der Marke «ELASTOSIL» RT-604 ausgebildet. Die lichtempfindlichen Sensoren stellen geschaltete genormte Siliziumsonnenzellen 2 dar. Die Reihen von lichtempfindlichen Sensoren 2 sind auf der wärmeleitfähigen Unterlage 11 angeordnet. Die Länge jeder Kette von Zellen beträgt 500 mm und die Breite 10 mm.

Die Rohre 4 der Baugruppe für einen Feuchtigkeitsschutz sind aus Aluminium mit einer geschwärzten Außenoberfläche gefertigt, um die Wärmeverluste durch Wiederausstrahlung zu vermindern. Die Rohre 4 sind mit Kieselgel der Marke "KC-Trockenperlen" (mit einer spezifischen Wärmekapazität von 1 KJ/kg: × °K, einer Wärmeleitfähigkeit von 0,2 Wt/m × °K und einer durchschnittlichen Korngröße von 3,5 mm) gefüllt.

Die Rohre 4 sind auseinandemehmbar ausgeführt. Die Stimteile 7 und 6 werden in das Rohr 4 nach der Auffüllung mit Kieselgel eingeschraubt. Die Rohre 4 werden im Modul anhand einer Verschraubung in der Wand 8 befestigt. Um das Kieselgel innerhalb der Rohre 4 zu fixieren, sind Metallgitter mit einer Maschengröße von 1,0×1,0 mm verwendet. Sie sind an ihren Stirnseiten 7 und 6 beim Zusammenbau des eingefüllten Rohres 4 befestigt.

Die Rückgewinnung des verwendeten Kieselgels erfolgt bei einer Temperatur von 90°C. Das wird dank der Erwärmung der Rohre 4 mittels einer zusätzlichen Fresnet-Linse 3 sichergestellt.

Der Taupunkt für die Wasserdämpfe innerhalb des Moduls unter den Bedingungen einer totalen Sonnenbelichtung, gemessen mit einem tragbaren Mikroprozessormessgerät der Mikrofeuchtigkeit 1.9 IVG-1 K-P, beträgt max. Minus 75°C.

Somit ermöglicht das photoelektrische Konzentratormodul mit einer Schleusenbaugruppe mit einem regenerierbaren Feuchte aufnehmenden Stoff (z.B. Kieselgel), den Feuchtigkeitsniederschlag auf den Bauteilen innerhalb des Moduls völlig auszuschließen- Dadurch wird die Stabilität der elektrophysikalischen und optischen Kennlinien des Moduls sichergestellt.

### Literaturhinweise:

[1.] Zh.1. Alferov, V.M. Andreev, V.D. Rumyantsev. Trends und Aussichten der Entwicklung der Photonenenergie der Sonne. - Zeitschrift "Halbleiterphysik und -technik", 2004, Band 38, Ausgabe 8, S. 937-948.
[2.] Patent der USA. IPC: H01 L 31/052, Nr. 5,505,789 vom 09. April 1996.
[3.] Internationale Anmeldung. IPC: H01 L 311052, Nr. WO 2006/049524 vom 01. November 2004.

## Patentansprüche

1. Photoelektrisches Konzentratormodul mit einem abgedichteten Innenraum, einschließlich linearer Fresnel-Linsen (1), einer Kette von lichtempfindlichen Sensoren (2) und einer Schleusenbaugruppe, die den abdichtbaren Innenraum mit der Außenluft verbindet,
**dadurch gekennzeichnet,**
**dass** die Schleusenbaugruppe als ein erwärmbares und mit Luftfeuchtigkeitssorbens gefülltes Rohr (4) ausgeführt ist, um den Modulinnenraum vor Luftfeuchtigkeit zu schützen.

2. Photoelektrisches Konzentratormodul nach Anspruch 1,
**dadurch gekennzeichnet,**
**dass** die mit Sorbens gefüllten Rohre (4) parallel zu den Reihen der lichtempfindlichen Sensoren (2) angeordnet sind und dass
die Erwärmung durch zusätzliche Fresnel-Linsen (3) erfolgt.

3. Photoelektrisches Konzentratormodul nach Anspruch 1,
**dadurch gekennzeichnet,**
**dass** die Rohre (4) den Innenraum des Moduls über die Stirnflächen (6) mit der Umgebung über die Stirnflächen (7) des Moduls verbinden.

4. Photoelektrisches Konzentratormodul nach Anspruch 1,
**dadurch gekennzeichnet,**
**dass** die Haupt-Fresnei-Linsen (1) aus Silikon auf einer Glasunterlage (9) ausgebildet sind.

5. Photoelektrisches Konzentratormodul nach Anspruch 1,
**dadurch gekennzeichnet,**
**dass** die Hilfs-Fresnel-Linsen (3) gleich aufgebaut und neben den Haupt-Fresnel-Linsen angeordnet sind.

6. Photoelektrisches Konzentratormodul nach Anspruch 1,
**dadurch gekennzeichnet,**
**dass** die Reihen von Sonnenzellen (2) durch eine Wärme abführende Schicht (11) auf der Metallunterlage des Gehäuses (8) getrennt angeordnet sind.

7. Photoelektrisches Konzentratormodul nach Anspruch 1,
**dadurch gekennzeichnet,**
**dass** alle Sonnenzellen (2) in Reihe geschaltet sind.

8. Photoelektrisches Konzentratormodul nach Anspruch 1,
**dadurch gekennzeichnet,**
**dass** die elektrischen Ableitungen über abisolierte Klemmen auf den Seitenflächen (8) des Moduls nach außen geführt sind.

9. Photoelektrisches Konzentratormodul nach Anspruch 1,
**dadurch gekennzeichnet,**
**dass** die Hilfs-Fresnel-Linsen (3) so ausgebildet sind, dass sie die Lichtstrahlen (10) auf die mit Sorbens gefüllten Rohre (4) konzentrieren.

10. Photoelektrisches Konzentratormodul nach Anspruch 9,
**dadurch gekennzeichnet,**
**dass** die Rohre (4) mit geschwärzter Oberfläche versehen sind, um ein höchstmögliches Aufnahmevermögen der konzentrierten Lichtstrahlen (10) zu erreichen.

11. Photoelektrisches Konzentratormodul nach Anspruch 1,
**dadurch gekennzeichnet,**
**dass** eine effiziente Desorption des Wasserdampfes aus dem Sorptionsmittel in den Rohren (4) durch eine erhöhte Rohrtemperatur erreicht ist, die unter der Einwirkung eines intensiven Lichtstrahls (10) gewonnen ist.

12. Photoelektrisches Konzentratormodul nach Anspruch 1,
**dadurch gekennzeichnet,**
**dass** als Sorbens in den Rohren (4) ein Feuchtigkeit aufnehmender Stoff, z.B. Kieselgel, verwendet ist.

13. Photoelektrisches Konzentratormodul nach Anspruch 12,
**dadurch gekennzeichnet,**
**dass** das Sorbens eine Rückgewinnungstemperatur von 45-100°C aufweist.

14. Photoelektrisches Konzentratormodul nach Anspruch 1,
**dadurch gekennzeichnet,**
**dass** das Gehäuse (8) des Moduls aus Metall, z.B. Aluminium, besteht.

15. Photoelektrisches Konzentratormodul nach Anspruch 14,
**dadurch gekennzeichnet,**
**dass** das Gehäuse (8) eine steife Bauweise aufweist, um ein präzises Fokussieren der Lichtstrahlen (10) auf die Oberfläche der Reihe von lichtempfindlichen Sensoren (2) und auf die Oberfläche der Rohre (4) der Schleusenbaugruppe sicherzustellen.

16. Photoelektrisches Konzentratormodul nach Anspruch 1,
**dadurch gekennzeichnet,**
**dass** das Gehäuse (8) aus Metall besteht, das mit einem Deckel (9) aus Glas abgedeckt ist, der 2 mm stark ist und einen Durchsichtigkeitsgrad von 96% aufweist.

17. Photoelektrisches Konzentratormodul nach Anspruch 1,
**dadurch gekennzeichnet,**
**dass** die Sonnenzellen (2) als Siliziumsonnenzellen ausgebildet sind.

18. Photoelektrisches Konzentratormodul nach Anspruch 12,
**dadurch gekennzeichnet,**
**dass** das Kieselgel eine spezifische Wärmekapazität von 1 KJ/kg ×°K, eine Wärmeleitfähigkeit von 0,2 Wt/m ×°K und eine durchschnittliche Korngröße von 3,5mm aufweist.

## Geänderte Patentansprüche

### Geänderte Patentansprüche gemäss Regel 137(2) EPÜ.

**1.** Photoelektrisches Konzentratormodul mit einem abgedichteten Innenraum, einschließlich linearer Haupt-Fresnel-Linsen (1), einer Kette von lichtempfindlichen Sensoren (2) und einer Schleusenbaugruppe, die den abdichtbaren Innenraum mit der Außenluft verbindet, wobei die Schleusenbaugruppe als ein mit Luftfeuchtigkeitssorbens gefülltes Rohr (4) ausgeführt ist, um den Modulinnenraum vor Luftfeuchtigkeit zu schützen,
**dadurch gekennzeichnet,**
**dass** die mit Sorbens gefüllten Rohre (4) parallel zu den Reihen der lichtempfindlichen Sensoren (2) angeordnet sind und dass die Erwärmung durch zusätzliche Hilfs-Fresnel-Linsen (3) erfolgt, wobei die Hilfs-Fresnel-Linsen (3) so ausgebildet sind, dass sie die Lichtstrahlen (10) auf die mit Sorbens gefüllten Rohre (4) konzentrieren.

**2.** Photoelektrisches Konzentratormodul nach Anspruch 1,
**dadurch gekennzeichnet,**
**dass** die Rohre (4) den Innenraum des Moduls über die Stirnflächen (6) mit der Umgebung über die Stirnflächen (7) des Moduls verbinden.

**3.** Photoelektrisches Konzentratormodul nach Anspruch 1,
**dadurch gekennzeichnet,**
**dass** die Haupt-Fresnel-Linsen (1) aus Silikon auf einer Glasunterlage (9) ausgebildet sind.

**4.** Photoelektrisches Konzentratormodul nach Anspruch 1,
**dadurch gekennzeichnet,**
**dass** die Hilfs-Fresnel-Linsen (3) gleich aufgebaut und neben den Haupt-Fresnel-Linsen angeordnet sind.

**5.** Photoelektrisches Konzentratormodul nach Anspruch 1,
**dadurch gekennzeichnet,**
**dass** die Reihen von Sonnenzellen (2) durch eine Wärme abführende Schicht (11) auf der Metallunterlage des Gehäuses (8) getrennt angeordnet sind.

**6.** Photoelektrisches Konzentratormodul nach Anspruch 1,
**dadurch gekennzeichnet,**
**dass** alle Sonnenzellen (2) in Reihe geschaltet sind.

**7.** Photoelektrisches Konzentratormodul nach Anspruch 1,
**dadurch gekennzeichnet,**
**dass** die elektrischen Ableitungen über abisolierte Klemmen auf den Seitenflächen (8) des Moduls nach außen geführt sind.

**8.** Photoelektrisches Konzentratormodul nach Anspruch 1,
**dadurch gekennzeichnet,**
**dass** die Rohre (4) mit geschwärzter Oberfläche versehen sind, um ein höchstmögliches Aufnahmevermögen der konzentrierten Lichtstrahlen (10) zu erreichen.

**9.** Photoelektrisches Konzentratormodul nach Anspruch 1,
**dadurch gekennzeichnet,**
**dass** eine effiziente Desorption des Wasserdampfes aus dem Sorptionsmittel in den Rohren (4) durch eine erhöhte Rohrtemperatur erreicht ist, die unter der Einwirkung eines intensiven Lichtstrahls (10) gewonnen ist.

**10.** Photoelektrisches Konzentratormodul nach Anspruch 1,
**dadurch gekennzeichnet,**
**dass** als Sorbens in den Rohren (4) ein Feuchtigkeit aufnehmender Stoff, z.B. Kieselgel, verwendet ist.

**11.** Photoelektrisches Konzentratormodul nach Anspruch 10,
**dadurch gekennzeichnet,**
**dass** das Sorbens eine Rückgewinnungstemperatur von 45-100°C aufweist.

**12.** Photoelektrisches Konzentratormodul nach Anspruch 1,
**dadurch gekennzeichnet,**
**dass** das Gehäuse (8) des Moduls aus Metall, z.B. Aluminium, besteht.

**13.** Photoelektrisches Konzentratormodul nach Anspruch 12,
**dadurch gekennzeichnet,**
**dass** das Gehäuse (8) eine steife Bauweise aufweist, um ein präzises Fokussieren der Lichtstrahlen (10) auf die Oberfläche der Reihe von lichtempfindlichen Sensoren (2) und auf die Oberfläche der Rohre (4) der Schleusenbaugruppe sicherzustellen.

**14.** Photoelektrisches Konzentratormodul nach Anspruch 1,
**dadurch gekennzeichnet,**
**dass** das Gehäuse (8) aus Metall besteht, das mit einem Deckel (9) aus Glas abgedeckt ist, der 2 mm stark ist und einen Durchsichtigkeitsgrad von 96% aufweist.

**15.** Photoelektrisches Konzentratormodul nach Anspruch 1,
**dadurch gekennzeichnet,**
**dass** die Sonnenzellen (2) als Siliziumsonnenzellen ausgebildet sind.

**16.** Photoelektrisches Konzentratormodul nach Anspruch 10,
**dadurch gekennzeichnet,**
**dass** das Kieselgel eine spezifische Wärmekapazität von 1KJ/kg ×°K, eine Wärmeleitfähigkeit von 0,2 Wt/m ×°K und eine durchschnittliche Korngröße von 3,5mm aufweist.
